(19) Europäisches Patentamt
European Patent Office
Office européen des brevets

(11) **EP 3 072 995 B1**

(12) **EUROPEAN PATENT SPECIFICATION**

(45) Date of publication and mention of the grant of the patent:
**06.05.2020 Bulletin 2020/19**

(51) Int Cl.:
**C30B 23/00** *(2006.01)*    **C30B 29/36** *(2006.01)*

(21) Application number: **15161654.7**

(22) Date of filing: **30.03.2015**

(54) **METHOD FOR PRODUCING SILICON CARBIDE CRYSTALS FROM VAPOUR PHASE**

VERFAHREN ZUR KRISTALLENZÜCHTUNG VON SILIZIUMKARBID MITTELS VERDAMPFUNG

MÉTHODE DE CROISSANCE DE CRISTAUX EN CARBURE DE SILICIUM PAR PHASE GASEUSE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **25.03.2015 PL 41169515**

(43) Date of publication of application:
**28.09.2016 Bulletin 2016/39**

(73) Proprietor: **Siec Badawcza Lukasiewicz- Instytut Technologii Materialow Elektronicznych 01-919 Warszawa (PL)**

(72) Inventors:
• **Tymicki, Emil 01-922 Warszawa (PL)**
• **Grasza, Krzysztof 03-743 Warszawa (PL)**
• **Racka - Szmidt, Katarzyna 01-864 Warszawa (PL)**

(74) Representative: **AOMB Polska Sp. z.o.o. Ul. Emilii Plater 53 21st Floor 00-113 Warsaw (PL)**

(56) References cited:
**EP-A1- 1 354 987        EP-A1- 2 371 997
WO-A1-2007/135965        JP-A- 2007 314 358
US-A1- 2010 139 552**

• **KRZYSZTOF GRASZA ET AL: "Experimental Verification of a Novel System for the Growth of SiC Single Crystals", MATERIALS SCIENCE FORUM, vol. 679-680, 28 March 2011 (2011-03-28), pages 16-19, XP055295132, CH ISSN: 0255-5476, DOI: 10.4028/www.scientific.net/MSF.679-680.16**

## Description

The object of the invention is a method of producing long crystals of silicon carbide (SiC) from vapour phase, applicable in electronics of high-powers and high frequencies and in optoelectronics as a material for substrates under epitaxial structures. Monocrystalline silicon carbide is also an excellent substrate material for the production of graphene which has unique properties. It is predicted that it may revolutionise many areas of technology.

Growth of silicon carbide crystals from vapour phase was started by Lely in 1955 [A. J. Lely, Ber. Deut. Keram. Ges. 32 (1955) 229.]. His method was based on thermal decomposition (sublimation) of silicon carbide placed inside a heater. In a warmer zone of the heater, the process of sublimation occurred, and in a colder one, there was the process of spontaneous crystallization. This method is used until today for the preparation of silicon carbide crystals in the form of plates, the size of which reaches up to several millimetres. In 1974, a breakthrough occurred, this method was modified by Tsvetkov and Tariov, they used a monocrystalline seed in the form of SiC plates [Y.M.Tairov, V.F.Tsvetkow, J.Crystal Growth, 43 (1978) 209]. This method allowed for the production of crystals with greater diameters, which contributed to the dynamic development of SiC technology. This method was also modified but the idea remained the same. Currently, SiC crystals with a maximum diameter of 150 mm and a length of several centimetres are obtained with this method.

Method consisting in the use of seed consists in that it is placed in a cooler area of the growth chamber, and the source material is placed in a warmer area. At high temperature, the process of intensive thermal decomposition of SiC source material into $Si$, $Si_2$, $Si_2C$, $SiC_2$ molecules occurs. These molecules are then transported by diffusion and convection to the surface of the seed, where the crystallization process occurs. The process of crystal growth lasts 50-250 h, and the crystal, obtained during this time, has a length of 10-40 mm.

Some crystals of silicon carbide are also prepared by other methods, e.g. 3C-SiC crystals, because they are not stable at temperatures above 1800 °C, are obtained from Si-C solution at a temperature of 1450 - 1800 °C [T. Ujihara, R. Maekawa, R. Tanaka, K. Sasaki, K. Kurodab, Y. Takeda, J. Cryst. Growth 310 (2008) 1438.]. In turn, crystals with electrical properties of semi-insulation, i.e. with increased resistivity, due to impurities which are in the source material, are obtained with chemical method of epitaxy HTCVD (High Temperature Chemical Vapour Deposition) from gases, e.g. propane and silane of very high purity [O. Kordina, C. Hallin, A. Ellison, A. S. Bakin, I. G. Ivanov, A. Henry, R. Yakimova, M. Touminen, A. Vehanen, E. Janzen, , Appl. Phys. Lett. 69 (1996) 1456].

EP1354987 discloses a method of producing silicon carbide crystals in a furnace comprising an upper heater, a lower heater, located beneath the upper heater, and a growth chamber, located inside the upper heater, provided with a crucible for a source material and a crucible cover allowing fixing of a monocrystalline seed thereon, The monocrystalline seed is placed in an upper part of the growth chamber, and the source material is placed in the crucible. The growth chamber is filled with an inert gas. By means of the upper and lower heaters, the monocrystalline seed is heated to a temperature higher than 2150°C, and the source material to a higher temperature. During the process, the source material is maintained at a higher temperature than the seed. Under these conditions, thermal decomposition of the source material and crystallization of silicon carbide on the monocrystalline seed are performed to give a silicon carbide crystal. During the crystallization of silicon carbide on the monocrystalline seed, power supplied to the upper heater and power supplied do the lower heater are changed over time with growing of the crystal.

EP2371997 relates to a method for manufacturing crystals, in particular of silicon carbide, from gaseous phase. The method according to the invention consists in that a monocrystalline seed in a form of a wafer, mounted in a ring of a high purity graphite such that only its edge abuts directly with the ring, is placed in the upper part of the growth chamber filled with an inert gas or with a gas ensuring doping of the crystal, with the feedstock deposited on its bottom, after which the seed is heated up to the crystallization temperature at the condition of a high pressure of the gas filling the chamber and a higher temperature in the lower part of the chamber is maintained while preserving the temperature difference between the feedstock and the seed in the range of 50°C to 300°C.

Also publication KRZYSZTOF GRASZA ET AL, "Experimental Verification of a Novel System for the Growth of SiC Single Crystals" (MATERIALS SCIENCE FORUM, vol. 679-680, 1 March 2011 (2011-01-11), pages 16-19, CH; ISSN 0255-5476, DOI:10.4028/www.scientific.net/MSF.679-680.16) relates to a method of producing SiC crystals and discloses to change the power supplied to the upper and to the lower heater.

To determine the essence of the present invention, it is important to define the concept of thickness or length of the obtained crystal of silicon carbide. In the remaining part of the description, these terms are used interchangeably, and both of them refer to a dimension measured transversely (i.e. in the normal direction) to the surface of the monocrystalline seed used in the growth process. Because the seed is in the shape of a flat plate, initially, this dimension is much smaller than the other two dimensions of the plate. Then, it is convenient to speak of "thickness" of the seed and "thickness" of the crystal. However, due to the successful growth process, this dimension is increased - preferably even to above 60 mm. Thus it could be the largest dimension of the obtained crystal - and then, it would be convenient to speak of "length".

With the growth of the crystal, its crystallization front (surface between the growing crystal and the gaseous phase) moves to the warmer zone. Its thickness is also increased, which impedes the flow of heat along the crystal axis. These factors result in an increase in temperature on the surface of the crystal growth, which in turn translates into a reduction in the crystallization rate. In the case of crystals with a length greater than 50 mm, the surface temperature of the crystal growth is the same as the temperature of the source material [T.S Sudarshan, S. I. Maximenko, Microelectronic Engineering 83 (2006) 155-159]. Then, an isothermal system is formed and the crystallization process disappears completely.

The temperature field, which is appropriately shaped and, more importantly, is changing, during the growth of the crystal length, allows obtaining a crystal with a much greater length than it is possible in stationary conditions. The temperature field during the crystal growth can be changed by using two or more independent sources of heat. In this invention, two independent graphite heaters, which are heated in a resistive manner, are used.

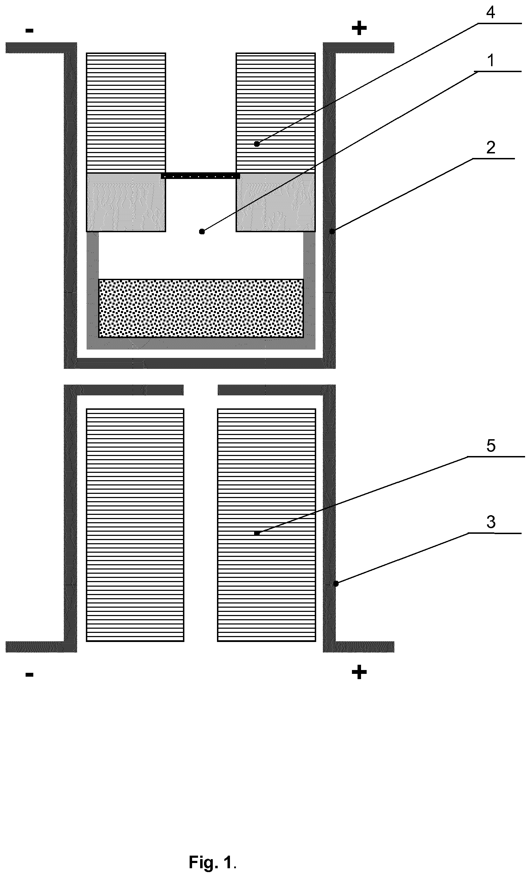

The object of the invention is a method for the production of long monocrystals of silicon carbide with the use of a furnace for SiC monocrystallization, the furnace comprising two heaters, i.e. an upper heater which serves as a main heater and a lower heater which serves as an additional heater (Fig. 1). Inside the upper heater, there is a growth chamber, and the lower heater is located under the upper heater. It heats the growth chamber from the bottom. With this method, the temperature difference between the source material and the surface of the crystal growth can be increased. Furthermore, with the additional heater, the shape of the crystallization front during the crystal growth can be controlled to a certain extent. This solution allows a high yield of the crystallization process by increasing the length of the obtained crystals.

The invention relates to the methods of producing silicon carbide crystals according to the appended claims.

The method according to the invention - in the most general terms - consists in that the temperature field in the growth chamber during the crystallization process is modified as a function of crystal length. In such a manner that the power supplied to the lower and upper heaters is modified smoothly depending on the length of the crystal being obtained.

In order to explain the method of heating the growth chamber, the following designations were introduced:

$P_g$ - power supplied to the upper heater;

$P_d$ - power supplied to the lower heater.

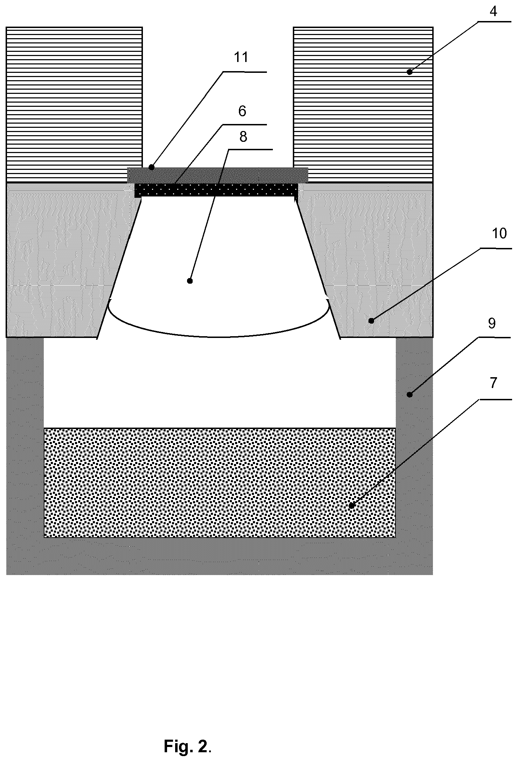

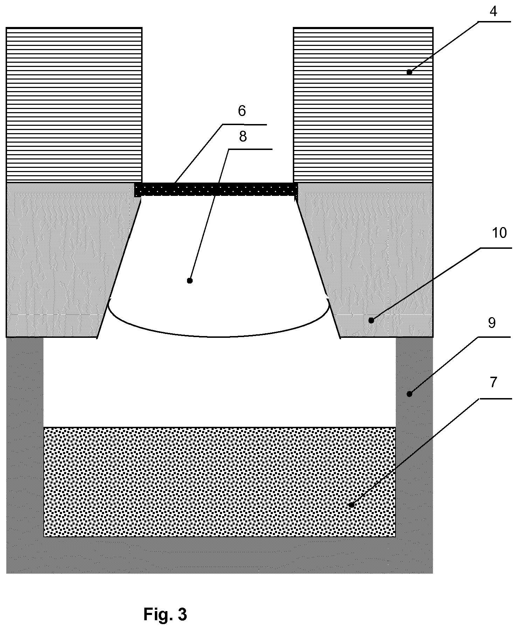

The invention is used for two methods of fixing the monocrystalline seed. In the first case, the seed is adhered to a graphite plate, and its rear surface is completely covered (Fig. 2). In the other method, a plate is fixed on the edge of the inner opening of the crucible cover, and its rear surface is completely uncovered (Fig. 3). The method of heating in the first phase of the crystal growth will vary depending on the method of fixing the seed. In the later part of the crystallization process, in both cases, the method of heating will be similar.

In the first case, when the rear surface of the seed is covered e.g. with a graphite plate, it is preferable to form a substantial radial gradient on the growth surface of seed in the first phase of the crystal growth - this will allow growth of the crystal with a convex growth surface, and more importantly, will reduce the phenomenon of formation of many crystallization nuclei. It is intended to have, at the top of the convex crystallization front, just one source of crystallization degrees, from which crystallization degrees will propagate uniformly from the centre to the edge of the crystal. This allows for stabilisation of polytype, degree of doping and improves the stability of the growth surface morphology. Convexity of the crystallization front can not be too large because internal stresses will be created in the crystal and there will be a risk of crystallization steps being grouped. The crystallization front is intended to be characterised by a small convexity. Convexity is measured with an inclination angle between a tangent drawn at the growth surface to a tangent to the seed surface at the crystal edge. The optimal size of this angle is equal to $\alpha \sim 3.5°$.

The largest radial gradient is obtained when the largest ratio of $\dfrac{P_g}{P_d}$ is maintained, i.e. when the highest possible power is supplied to the upper heater, and the lowest power to the lower one. In order to reduce the formation of internal stresses due to the radial gradient, after the crystal reaches a thickness of 3 mm, value $\dfrac{P_g}{P_d}$ is reduced in a smooth manner. While maintaining the radial gradient which allows the growth of the crystal with a convex crystallization front, where angle $\alpha \sim 3.5°$. With the increase in the length of the crystal, heat flow through the crystal is becoming more difficult, which causes a temperature rise on the surface of the crystal growth. In these conditions, crystallization rate decreases and the crystallization front becomes flat, and even concave. In order to maintain the temperature difference between the source material and the surface of the growing crystal, it is preferable to reduce the ratio of $\dfrac{P_g}{P_d}$, i.e. a higher power will be supplied to the lower heater, and the same or lower power to the upper one. The presented method allows obtaining crystals with a length greater than 6 cm. Crystals, when growing, have a convex crystallization front, which positively affects their crystalline quality and their optical and electrical properties.

In the second case, when the rear surface of the seed is uncovered, formation of a large radial gradient in the first phase of the crystal growth is disadvantageous because of the risk of thermal etching of the seed at its edge. For this reason, it is preferable to maintain the smallest ratio of $\dfrac{P_g}{P_d}$, i.e. a lower power is supplied to the upper heater, and a power higher than in the later part of the growth process is supplied to the lower one. This will reduce the risk of thermal etching of the seed, which is the highest in the first phase of growth when the thickness of the crystal is small. Further, it occurs mainly at the edge of the seed, therefore, it is preferable to maintain the smallest radial temperature distribution. Such conditions result in the shape of the growth surface being flat. In the later stage of growth, when the thickness of the crystal is greater than 3 mm, in order to give the crystal a convex shape, it is preferable to increase the heating with the upper heater, i.e. to increase the ratio of $\dfrac{P_g}{P_d}$.

Then, in order to maintain the convex crystallization front with a convexity $\alpha \sim 3.5°$, it is necessary to control the ratio of $\dfrac{P_g}{P_d}$. Similarly to the first case, in order to maintain the temperature difference between the source material and the surface of the growing crystal, it is preferable to reduce the ratio of $\dfrac{P_g}{P_d}$, i.e. a higher power will be supplied to the lower heater, and the same or lower power to the upper one.

The presented method allows obtaining crystals with a length greater than 6 cm. Apart from the first phase of growth, crystals, when growing, have a convex crystallization front, which positively affects their crystalline quality and their optical and electrical properties.

**Advantageous effects of the invention**

Possibility of growth of longer crystals preferably reduces the cost of the process. From the obtained crystals, a larger amount of plates, which are substrates for the production of electronic devices, is preferably obtained. From one seed, a larger amount of plates is preferably obtained, which lowers the cost of production of the obtained substrates. Crystal growth processes consist of many steps, i.e. preparation of the system, obtaining a vacuum in the furnace chamber, then heating the growth chamber to the temperature of crystallization and cooling the growth chamber and its unloading. By obtaining longer crystals, the impact of steps in which crystal growth does not take place on the process efficiency is reduced. Furthermore, in the process of obtaining plates from the crystal, it has preferably a greater length because this allows for better efficiency when it is being cut into plates.

In the invention, a monocrystalline seed in the form of a SiC plate with a polished surface on which the crystal growth will take place is preferably used. In the method of fixing the seed by adhering it to a graphite plate, organic adhesives or a graphite paste are preferably used. In the method of fixing the plate with an uncovered rear surface, the plate is preferably fixed with its edge on an annular shoulder constituting an integral part of the crucible cover. If necessary, the seed edge is sealed preferably by means of a graphite paste and is covered with an additional graphite ring. Preparation of the seed in this method is preferably limited to polishing of only one front surface of the plate without the need to maintain the flatness of the rear surface of the plate, which results in a considerable time saving.

Preferably, the seed in the plane (0001) crystallographically oriented along a direction consistent with crystallographic axis c is commonly used, but is also possible to use seeds with other crystallographic orientations. For 4H-SiC crystal growth, carbon surface of the seed is preferably used, and for 6H-SiC crystal growth, silicon surface of the seed is preferably used. The used seed in the form of a plate preferably has a thickness of 1-2 mm.

As the source material, silicon carbide is preferably used, which, depending on the intended properties of the obtained crystal, is used without dopants or is intentionally enriched with dopants, such as boron, vanadium, cerium, aluminum, iron and/or excessive stoichiometric silicon or carbon, SiC source material has preferably the form of powder, granulate or recrystallised SiC material.

As the gas which fills the growth chamber, typically argon, nitrogen, hydrogen and/or helium are used.

In order to produce a nitrogen-doped crystal, silicon carbide, as the source material, is placed in the growth chamber filled with nitrogen or with an inert gas containing nitrogen.

The seed is preferably heated to a temperature of 2000-2300 °C, on its rear surface, and the source material to a temperature of 2100-2400 °C.

The process is carried out using a temperature field and a field of partial pressures of vapours from which a crystal is formed, adapted to the speed of crystal growth preferably in the range of 0.01-2 mm/h.

The method according to the invention provides a high reproducibility of long 4H- and 6H-SiC crystals of the same polytype. The invention also allows a controlled and homogeneous doping which allows production of crystals with a wide range of electrical and optical properties. This also allows the use of a nonconventional direction of crystallization.

**Preferred Embodiments of the Invention**

Preferred embodiments of the invention are described below with reference to the drawing, in which:

Fig. 1. shows a diagram of a method of arranging two heaters and arranging a growth chamber in an upper heater.

Fig. 2. shows a growth chamber and presents a method of fixing a seed by adhering it to a graphite plate.

Fig. 3. shows the growth chamber and presents a method of fixing the seed with its rear surface uncovered.

Fig. 4. shows a method of heating in three steps of crystal growth from the seed with its rear surface covered: I step - beginning of crystal growth, II step - crystal growth from 3 to 30 mm in length, III step - crystal growth from 30 to 60 mm in length.

Fig. 5. shows a method of heating in three steps of crystal growth from the seed with its rear surface uncovered: I step - beginning of crystal growth, II step - crystal growth from 3 to 30 mm in length, III step - crystal growth from 30 to 60 mm in length.

Fig. 6. shows the relationship of the power supplied to the upper and lower heaters during the growth of a long crystal with its rear surface covered.

Fig. 7. shows the relationship of the power supplied to the upper and lower heaters during the growth of a long crystal with its rear surface uncovered.

**Designations used in the drawing:**

1.    Growth chamber
2.    Upper (main) heater
3.    Lower (additional) heater
4.    Insulation of the growth chamber
5.    Insulation of the lower heater
6.    Monocrystalline SiC seed
7.    SiC source material
8.    SiC monocrystal
9.    Crucible
10.   Crucible cover
11.   Cover covering the seed

**Example 1** (seed with its rear surface covered)

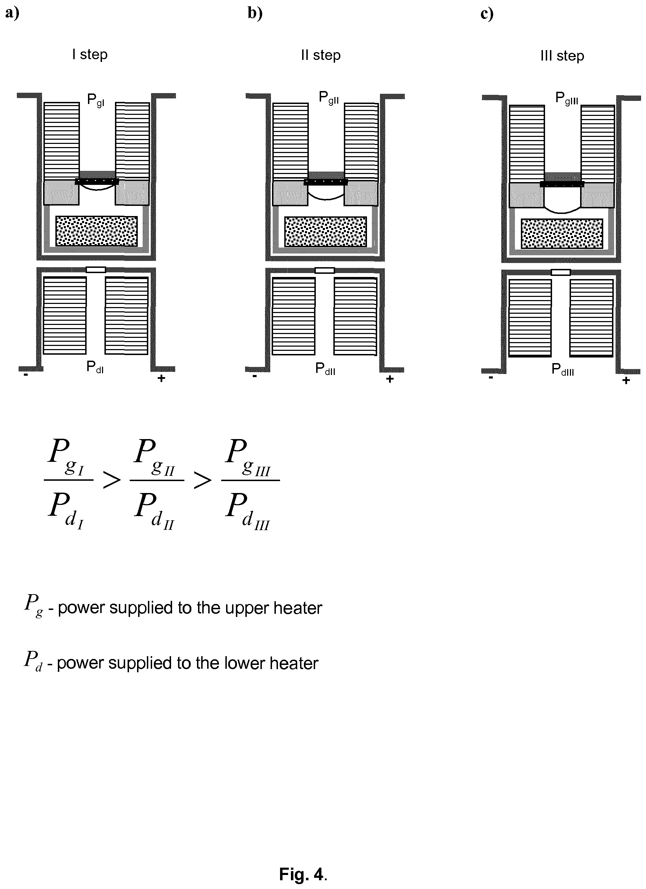

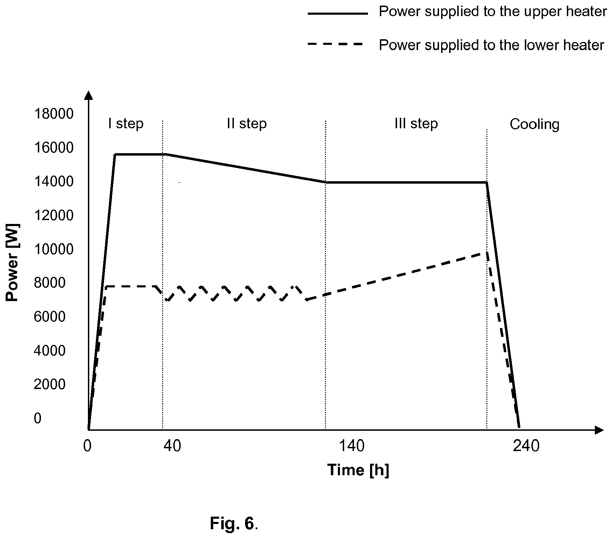

A growth chamber 1 is placed inside an upper heater 2 (Fig. 1). A lower heater 3 is located below the upper heater 2 and heats its bottom from below. The growth chamber 1 includes a graphite crucible 9 (Fig. 2) in which a source material 7 (Fig. 2) and a crucible cover 10 (Fig. 2) are located, a monocrystalline 4H-SiC seed 6 with orientation (000-1) (Fig. 2) being fixed to the said crucible cover so that its rear surface is covered with a graphite plate 11. In the first phase of growth (Fig. 4a and 6), the seed 6 is heated to a temperature of 2250 °C, and the source material 7 to a temperature of 2300 °C. Then, a constant power is supplied in an amount of 16000W to the upper heater 2 and 8000W to the lower heater 3 for 30 hours. In the second phase of growth (Fig. 4b and 6), the amount of power supplied to the upper heater 2 is reduced by 1000W, and the power supplied to the lower heater 3 is controlled until reaching a temperature of 2200 °C measured on crystal 8, while maintaining a temperature of 2300 °C of the source material 7. In the third phase of growth (Fig. 4c and 6), i.e. when the crystal 8 has a length greater than 30 mm, the power supplied to the lower heater 3 is increased until reaching a temperature of 2400 °C measured for the source material 7. The growth chamber 1 during the crystallization is filled with argon at a pressure of 2 kPa.

After 240 hours, a 4H-SiC crystal with a length of 60 mm was obtained. The crystal exhibited n-type electrical conductivity with $n$ carrier concentration ($6 \times 10^{17}$ cm$^{-3}$). The crystal grew at a rate of 0.25 mm/h.

**Example 2** (seed with its rear surface uncovered)

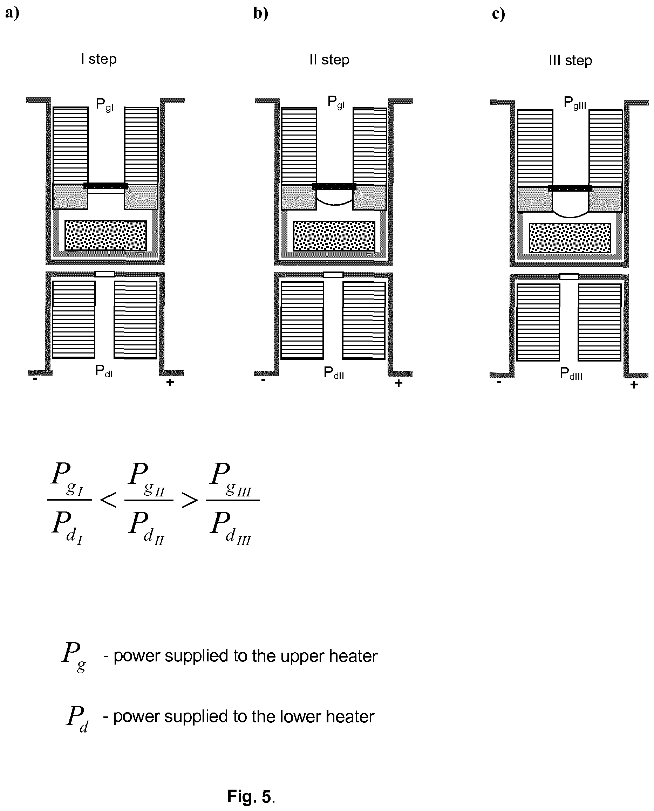

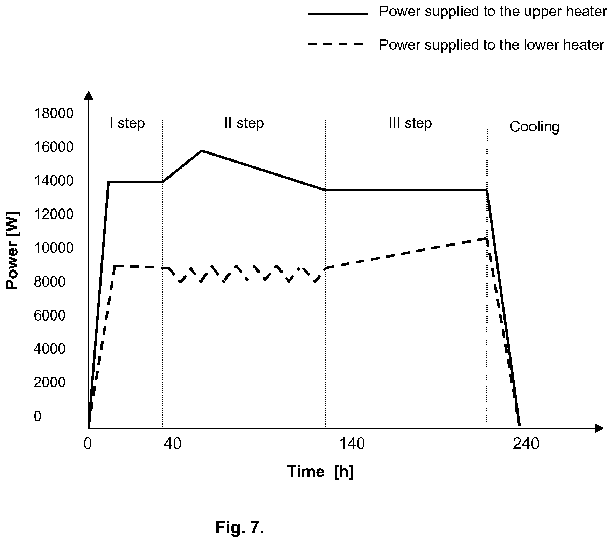

The growth chamber 1 was placed as in Example 1 except that the rear surface of the seed 6 is uncovered (Fig. 3). In the first phase of the process (Fig. 5a and 7), the seed 6 is heated to a temperature of 2150 °C, and the source material 7 to a temperature of 2300 °C. Then, a constant power is supplied in an amount of 14000 W to the upper heater 2 and 9000W to the lower heater 3 for 30 hours. In the second phase of the process (Fig. 4b and 7), the heating power for the upper heater 2 is smoothly increased by 2000W for 30 hours, and the power supplied to the lower heater 3 is controlled, then for 70 hours, the power supplied to the upper heater 2 is smoothly reduced until reaching a temperature of 2200 °C measured on the crystal 8, while maintaining a temperature of 2300 °C of the source material 7. In the third phase of growth (Fig. 5c and 7), i.e. when the crystal 8 has a length greater than 30 mm, the heating power for the lower heater 3 is increased until reaching a temperature of 2400 °C measured for the source material 7. The growth chamber 1 during the crystallization is filled with argon at a pressure of 2 kPa.

After 240 hours, a 4H-SiC crystal with a length of 60 mm was obtained. The crystal exhibited n-type electrical conductivity with $n$ carrier concentration ($6 \times 10^{17}$ cm$^{-3}$). The crystal grew at a rate of 0.25 mm/h.

**Example 3** (growth on silicon polarity - 6H-SiC crystal)

The growth chamber 1 was placed as in Example 1 except that the polarity of the seed 6 was changed to silicon one (0001). Other crystallization conditions were also as in Example 1.

After 240 hours, a 6H-SiC crystal with a length of 60 mm was obtained. The crystal exhibited n-type electrical conductivity with $n$ carrier concentration ($3 \times 10^{17}$ cm$^{-3}$). The crystal grew at a rate of 0.25 mm/h.

**Example 4** (nitrogen doping, growth on carbon polarity)

The growth chamber 1 (Fig. 1) and the seed 6 (Fig. 2) were placed as in Example 1. As an atmosphere of growth, a mixture of argon and nitrogen in a ratio of 90:10 at a pressure of 2 kPa was used. Thermal conditions were the same as in Example 1.

After 240 hours of crystallization, a 4H-SiC crystal with a length of 60 mm was obtained. The crystal exhibited n-type electrical conductivity with $n$ carrier concentration ($4\times10^{19}cm^{-3}$). The crystal grew at a rate of 0.25 mm/h.

**Example 5** (nitrogen doping, growth on silicon polarity)

The growth chamber 1 (Fig. 1) was placed as in Example 1, and the seed 6 as in Example 3. As an atmosphere of growth, a mixture of argon and nitrogen in a ratio of 90:10 at a pressure of 2 kPa was used. Thermal conditions were the same as in Example 1.

After 240 hours of crystallization, a 6H-SiC crystal with a length of 60 mm was obtained. The crystal exhibited n-type electrical conductivity with $n$ carrier concentration ($2\times10^{19}cm^{-3}$). The crystal grew at a rate of 0.25 mm/h.

**Example 6** (boron doping)

The growth chamber 1 (Fig. 1) was placed as in Example 1, and the seed 6 as in Example 3. In the graphite crucible 9, the source material 7 in the form of silicon carbide powder doped with boron was placed. Other crystallization conditions were also as in Example 1.

After 240 hours of crystallization, a 6H-SiC crystal with a length of 60 mm was obtained. The crystal exhibited p-type electrical conductivity with $n$ carrier concentration ($5\times10^{17}cm^{-3}$). The crystal grew at a rate of 0.25 mm/h.

**Example 7** (vanadium doping)

The growth chamber 1 (Fig. 1) and the seed 6 (Fig. 2) were placed as in Example 1. In the graphite crucible 9, the source material 7 in the form of recrystallised silicon carbide doped with vanadium was placed. Other crystallization conditions were also as in Example 1.

After 240 hours of crystallization, a 6H-SiC crystal with a length of 60 mm was obtained. After 240 hours of crystallization, a SiC crystal 4H-SiC with increased resistance of 1000 $\Omega$/cm was obtained. The SiC crystal grew at a rate of 0.25 mm/h.

**Claims**

1.  A method of producing silicon carbide crystals in a furnace comprising an upper heater, a lower heater, located beneath the upper heater, and a growth chamber, located inside the upper heater, provided with a crucible for a source material and a crucible cover allowing fixing of a monocrystalline seed thereon,

wherein

the monocrystalline seed is placed in an upper part of the growth chamber, and the source material is placed in the crucible,

the growth chamber is filled with an inert gas,

by means of the upper and lower heaters, the monocrystalline seed is heated to a temperature of at least 2150°C, and the source material to a higher temperature, preferably at least 2300°C,

during the process, the source material is maintained at a higher temperature than the seed,

and in these conditions, thermal decomposition of the source material and crystallization of silicon carbide on the monocrystalline seed are performed to give a silicon carbide crystal,

**characterised in that**

during the crystallization of silicon carbide on the monocrystalline seed, power $P_g$ supplied to the upper heater (2) and power $P_d$ supplied do the lower heater (3) are changed over time depending on the thickness of the growing crystal (8) in order to change the temperature field during the crystal growth,

wherein the rear surface of the monocrystalline seed (6), i.e. the surface which, in the growth process, faces outward relative to the crucible (9), is covered preferably with a graphite plate (11), and during the crystallization of silicon carbide on the monocrystalline seed (6)

a) first, $P_g/P_d$ power ratio is maximised, preferably by supplying the highest possible power $P_g$ to the upper heater (2) and the lowest possible power $P_d$ to the lower heater (3), until the growing crystal (8) reaches a thickness of about 3mm, and then

b) $P_g/P_d$ power ratio is reduced, preferably by supplying power $P_g$ lower than in the preceding step to the upper heater (2), until the growing crystal (8) reaches a thickness of about 30mm, and then

c) $P_g/P_d$ power ratio is further reduced in order to maintain the temperature difference between the source material and the surface of the growing crystal, preferably by supplying power $P_g$ higher than in the preceding step to the lower heater (3).

2.  The method according to claim 1, **characterised in that** in step b) power $P_g$ supplied to the upper heater (2) is gradually reduced over time.

3.  A method of producing silicon carbide crystals in a furnace comprising an upper heater, a lower heater, located beneath the upper heater, and a growth chamber, located inside the upper heater, provided with a crucible for a source material and a crucible cover allowing fixing of a monocrystalline seed thereon,
wherein
the monocrystalline seed is placed in an upper part of the growth chamber, and the source material is placed in the crucible,
the growth chamber is filled with an inert gas,
by means of the upper and lower heaters, the monocrystalline seed is heated to a temperature of at least 2150°C, and the source material to a higher temperature, preferably at least 2300°C,
during the process, the source material is maintained at a higher temperature than the seed,
and in these conditions, thermal decomposition of the source material and crystallization of silicon carbide on the monocrystalline seed are performed to give a silicon carbide crystal,
**characterised in that**
during the crystallization of silicon carbide on the monocrystalline seed, power $P_g$ supplied to the upper heater (2) and power $P_d$ supplied do the lower heater (3) are changed over time depending on the thickness of the growing crystal (8) in order to change the temperature field during the crystal growth,
wherein the rear surface of the monocrystalline seed (6), i.e. the surface which, in the growth process, faces outward relative to the crucible (9), is left uncovered, and during the crystallization of silicon carbide on the monocrystalline seed (6)

d) first, $P_g/P_d$ power ratio is minimised, preferably by supplying a lower power $P_g$ to the upper heater (2) and power $P_d$ not higher than in the preceding step to the lower heater (3), until the growing crystal (8) reaches a thickness of about 3mm, and then
e) $P_g/P_d$ power ratio is increased, preferably by supplying power $P_g$ higher than in the preceding step to the upper heater (2), until the growing crystal (8) reaches a thickness of about 30mm, and then
f) $P_g/P_d$ power ratio is reduced in order to maintain the temperature difference between the source material and the surface of the growing crystal, preferably by supplying power $P_g$ higher than in the preceding step to the lower heater (3).

4. The method according to claim 3, **characterised in that** in step e) power $P_g$ supplied to the upper heater (2) is gradually increased over time.

5. The method according to claim 1 or 3, **characterised in that** in step c) or f), power $P_d$ supplied to the lower heater (3) is gradually increased over time.

6. The method according to any one of claims 1 to 5, **characterised in that** a seed (6) in the form of a plate with only one front surface polished is used.

7. The method according to any one of claims 1 to 5, **characterised in that** a seed (6) crystallographically oriented along a direction consistent with crystallographic axis c is used.

8. The method according to any one of claims 1 to 5, **characterised in that** a seed (6) in the form of a plate having a thickness of 1-2 mm is used.

9. The method according to any one of claims 1 to 5, **characterised in that** as the seed (6), a 4H-SiC plate is used, preferably the one the growth surface, i.e. the surface which in the growth process faces inward relative to the crucible (9), of which has carbon polarity.

10. The method according to any one of claims 1 to 5, **characterised in that** as the seed (6), a 6H-SiC plate is used, preferably the one the growth surface, i.e. the surface which in the growth process faces inward relative to the crucible (9), of which has silicon polarity.

11. The method according to any one of claims 1 to 10, **characterised in that** as the source material, silicon carbide, possibly doped with boron, vanadium or aluminum, or silicon carbide of a non-stoichiometric composition, containing an excess of silicon or carbon, is used.

12. The method according to any one of claims 1 to 11, **characterised in that** the inert gas contains nitrogen or the inert gas is nitrogen.

13. The method according to any one of claims 1 to 12, **characterised in that** the seed (6) is heated to a temperature of 2150-2300°C on its rear surface.

14. The method according to any one of claims 1 to 13, **characterised in that** the process is carried out using a temperature field and a field of partial pressures of vapours from which a crystal is formed, adapted to the speed of crystal growth in the range of 0.01-2 mm/h.

**Patentansprüche**

1. Ein Verfahren zur Herstellung von Siliziumcarbid-Kristallen
in einem Ofen, der ein oberes Heizelement, ein unteres Heizelement, die sich unter der oberen Heizvorrichtung befindet, und eine Wachstumskammer, die sich im Inneren der oberen Heizvorrichtung befindet und mit einem Tiegel für ein Ausgangsmaterial und einem Tiegeldeckel versehen ist, der die Fixierung eines monokristallinen Keimes darauf ermöglicht, umfasst,

wobei

der monokristalline Keim in einen oberen Teil der Wachstumskammer gelegt und das Ausgangsmaterial in den Tiegel gegeben wird,

die Wachstumskammer mit Inertgas gefüllt ist,

mit Hilfe der oberen und unteren Heizelemente der monokristalline Keim auf eine Temperatur von mindestens 2150 °C und das Ausgangsmaterial auf eine höhere Temperatur, vorzugsweise auf mindestens 2300 °C, erhitzt werden,

während des Prozesses das Ausgangsmaterial auf einer höheren Temperatur als der Keim gehalten wird,

und unter diesen Bedingungen die thermische Zersetzung des Ausgangsmaterials und die Kristallisation von Siliziumcarbid auf dem monokristallinen Keim zu einem SiliziumcarbidKristall erfolgt,

**dadurch gekennzeichnet, dass**

während der Kristallisation von Siliziumkarbid auf dem monokristallinen Keim die dem oberen Heizelement (2) zugeführte Energie $P_g$ und die dem unteren Heizelement (3) zugeführte Energie $P_d$ in Abhängigkeit von der Dicke des wachsenden Kristalls (8) mit der Zeit verändert wird, um das Temperaturfeld während des Kristallwachstums zu verändern, wobei die Rückseite des monokristallinen Keimes (6), d.h. die Oberfläche, die im Wachstumsprozess relativ zum Tiegel (9) nach außen weist, vorzugsweise mit einer Graphitplatte (11) bedeckt ist, und während der Kristallisation von Siliziumcarbid auf dem monokristallinen Keim (6) ist,

a) zuerst wird das Leistungsverhältnis $P_g/P_d$ maximiert, vorzugsweise durch die Zufuhr der höchstmöglichen Leistung $P_g$ an das obere Heizelement (2) und der niedrigstmöglichen Leistung $P_d$ an das untere Heizelement (3), bis der wachsende Kristall (8) eine Dicke von etwa 3 mm erreicht, und dann

b) das Leistungsverhältnis $P_g/P_d$ wird reduziert, vorzugsweise durch die Zufuhr einer geringeren Leistung $P_g$ als im vorhergehenden Schritt an das oberen Heizelement (2), bis der wachsende Kristall (8) eine Dicke von etwa 30 mm erreicht, und dann

c) das Leistungsverhältnis $P_g/P_d$ wird weiter reduziert, um die Temperaturdifferenz zwischen dem Ausgangsmaterial und der Oberfläche des wachsenden Kristalls aufrechtzuerhalten, vorzugsweise durch die Zufuhr einer höheren Leistung $P_g$ als im vorhergehenden Schritt an das untere Heizelement (3).

2. Das Verfahren nach Anspruch 1, **dadurch gekennzeichnet, dass** in Schritt b) die dem oberen Heizelement (2) zugeführte Leistung $P_g$ mit der Zeit allmählich reduziert wird.

3. Ein Verfahren zur Herstellung von Siliziumcarbid-Kristallen

in einem Ofen, der ein oberes Heizelement, ein unteres Heizelement, die sich unter der oberen Heizvorrichtung befindet, und eine Wachstumskammer, die sich im Inneren der oberen Heizvorrichtung befindet und mit einem Tiegel für ein Ausgangsmaterial und einem Tiegeldeckel versehen ist, der die Fixierung eines monokristallinen Keimes darauf ermöglicht, umfasst,

wobei

der monokristalline Keim in einen oberen Teil der Wachstumskammer gelegt und das Ausgangsmaterial in den Tiegel gegeben wird,

die Wachstumskammer mit Inertgas gefüllt ist,

mit Hilfe der oberen und unteren Heizelemente der monokristalline Keim auf eine Temperatur von mindestens 2150 °C und das Ausgangsmaterial auf eine höhere Temperatur, vorzugsweise auf mindestens 2300 °C, erhitzt werden,

während des Prozesses das Ausgangsmaterial auf einer höheren Temperatur als der Keim gehalten wird,

und unter diesen Bedingungen die thermische Zersetzung des Ausgangsmaterials und die Kristallisation von Siliziumcarbid auf dem monokristallinen Keim zu einem Siliziumcarbidkristall erfolgt,

**dadurch gekennzeichnet, dass**

während der Kristallisation von Siliziumkarbid auf dem monokristallinen Keim die dem oberen Heizelement (2) zugeführte Leistung $P_g$ und die dem unteren Heizelement (3) zugeführte Leistung $P_d$ in Abhängigkeit von der Dicke des wachsenden Kristalls (8) mit der Zeit verändert wird, um das Temperaturfeld während des Kristallwachstums zu verändern, wobei die Rückseite des monokristallinen Keimes (6), d.h. die Oberfläche, die im Wachstumsprozess relativ zum Tiegel (9) nach außen weist, ungedeckt bleibt und während der Kristallisation von Siliziumcarbid auf dem monokristallinen Keim (6) ist,

d) zuerst wird das Leistungsverhältnis $P_g/P_d$ minimiert, vorzugsweise durch die Zufuhr der geringeren Leistung $P_g$ an das obere Heizelement (2) und der Leistung $Pd$ höher als im vorhergehenden Schritt an das untere Heizelement (3), bis der wachsende Kristall (8) eine Dicke von etwa 3 mm erreicht, und dann

e) das Leistungsverhältnis $P_g/P_d$ wird erhöht, vorzugsweise durch die Zufuhr einer höheren Leistung $P_g$ als im vorhergehenden Schritt an das oberen Heizelement (2), bis der wachsende Kristall (8) eine Dicke von etwa 30 mm erreicht, und dann

f) das Leistungsverhältnis $P_g/P_d$ wird reduziert, um die Temperaturdifferenz zwischen dem Ausgangsmaterial und der Oberfläche des wachsenden Kristalls aufrechtzuerhalten, vorzugsweise durch die Zufuhr einer höheren Leistung $P_g$ als im vorhergehenden Schritt an das untere Heizelement (3).

4. Das Verfahren nach Anspruch 3, **dadurch gekennzeichnet, dass** in Schritt e) die dem oberen Heizelement (2) zugeführte Leistung $P_g$ mit der Zeit allmählich erhöht wird.

5. Das Verfahren nach Anspruch 1 bzw. 3, **dadurch gekennzeichnet, dass** in Schritt c) die dem unteren Heizelement (3) zugeführte Leistung $P_g$ mit der Zeit allmählich erhöht wird.

6. Das Verfahren nach einem der Ansprüche 1 bis 5, **dadurch gekennzeichnet, dass** ein Keim (6) in Form einer Platte mit nur einer polierten Stirnfläche verwendet wird.

7. Das Verfahren nach einem der Ansprüche 1 bis 5, **dadurch gekennzeichnet, dass** ein Keim (6) verwendet wird, der kristallographisch entlang einer Richtung orientiert ist, die mit der kristallographischen Achse c übereinstimmt.

8. Das Verfahren nach einem der Ansprüche 1 bis 5, **dadurch gekennzeichnet, dass** ein Keim (6) in Form einer Platte mit einer Dicke von 1-2 mm verwendet wird.

9. Das Verfahren nach einem der Ansprüche 1 bis 5, **dadurch gekennzeichnet, dass** als Keim (6) eine 4H-SiC-Platte verwendet wird, vorzugsweise diejenige, die die Wachstumsoberfläche, d.h. die Oberfläche, die beim Wachstumsprozess nach innen in Bezug auf den Tiegel (9) weist, von dem die Polarität des Kohlenstoffs gegeben ist.

10. Das Verfahren nach einem der Ansprüche 1 bis 5, **dadurch gekennzeichnet, dass** als Keim (6) eine 6H-SiC-Platte verwendet wird, vorzugsweise diejenige, die die Wachstumsoberfläche, d.h. die Oberfläche, die beim Wachstumsprozess nach innen in Bezug auf den Tiegel (9) weist, von dem die Polarität des Siliziums gegeben ist.

11. Das Verfahren nach einem der Ansprüche 1 bis 10, **dadurch gekennzeichnet, dass** als Ausgangsmaterial Siliziumcarbid, gegebenenfalls angereichert mit Bor, Vanadium oder Aluminium, oder Siliziumcarbid einer nicht stöchiometrischen Zusammensetzung, das einen Überschuss an Silizium oder Kohlenstoff enthält, verwendet wird.

12. Das Verfahren nach einem der Ansprüche 1 bis 11, **dadurch gekennzeichnet, dass** das Inertgas Stickstoff enthält oder das Inertgas Stickstoff ist.

13. Das Verfahren nach einem der Ansprüche 1 bis 12, **dadurch gekennzeichnet, dass** der Keim (6) auf seiner Rückseite auf eine Temperatur von 2150-2300 °C erhitzt wird.

14. Das Verfahren nach einem der Ansprüche 1 bis 13, **dadurch gekennzeichnet, dass** das Verfahren unter Verwendung eines Temperaturfeldes und eines Feldes von Dampfpartialdrücken durchgeführt wird, aus denen ein Kristall gebildet wird, angepasst an die Geschwindigkeit des Kristallwachstums im Bereich von 0,01-2 mm/h.

**Revendications**

1. Une méthode de production de cristaux de carbure de silicium
dans un four comprenant un réchauffeur supérieur, un réchauffeur inférieur, situé sous le réchauffeur supérieur, et une chambre de croissance, située à l'intérieur du réchauffeur supérieur, pourvue d'un creuset pour un matériau source et d'un couvercle de creuset permettant la fixation d'une graine monocristalline dessus,
dans laquelle
la graine monocristalline est placée dans une partie supérieure de la chambre de croissance, et le matériau source est placé dans le creuset,
la chambre de croissance est remplie d'un gaz inerte,
au moyen des réchauffeurs supérieur et inférieur, la graine monocristalline est chauffée jusqu'à une température d'au moins 2150°C, et le matériau source jusqu'à une température plus élevée, de préférence au moins 2300°C,
pendant le processus, la matière source est maintenue à une température plus élevée que la graine,
et dans ces conditions, la décomposition thermique du matériau source et la cristallisation du carbure de silicium sur la graine monocristalline sont effectuées pour donner un cristal de carbure de silicium,
**caractérisée en ce que**
pendant la cristallisation du carbure de silicium sur la graine monocristalline, la puissance $P_g$ fournie au réchauffeur supérieur (2) et la puissance $P_d$ fournie au réchauffeur inférieur (3) sont modifiées dans le temps en fonction de l'épaisseur du cristal en croissance (8) afin de changer le champ de température pendant la croissance des cristaux,
dans laquelle la surface arrière de la graine monocristalline (6), c'est-à-dire la surface qui, dans le processus de croissance, fait face à l'extérieur par rapport au creuset (9), est recouverte de préférence d'une plaque de graphite (11), et pendant la cristallisation du carbure de silicium sur la graine monocristalline (6)

a) tout d'abord, le rapport de puissance $P_g/P_d$ est maximisé, de préférence en fournissant la puissance $P_g$ la plus élevée possible au réchauffeur supérieur (2) et la puissance $P_d$ la plus faible possible au réchauffeur inférieur (3), jusqu'à ce que le cristal en croissance (8) atteigne un épaisseur d'environ 3 mm, et puis

b) le rapport de puissance $P_g/P_d$ est réduit, de préférence en fournissant une puissance $P_g$ inférieure à l'étape précédente au réchauffeur supérieur (2), jusqu'à ce que le cristal en croissance (8) atteigne une épaisseur d'environ 30 mm, et puis

c) le rapport de puissance $P_g/P_d$ est encore réduit afin de maintenir la différence de température entre le matériau source et la surface du cristal en croissance, de préférence en fournissant une puissance $P_g$ supérieure à l'étape précédente au réchauffeur inférieur (3).

2. La méthode selon la revendication 1, **caractérisée en ce qu'**à l'étape b) la puissance $P_g$ fournie au réchauffeur supérieur (2) est progressivement réduite au fil du temps.

3. Une méthode de production de cristaux de carbure de silicium
dans un four comprenant un réchauffeur supérieur, un réchauffeur inférieur, situé sous le réchauffeur supérieur, et une chambre de croissance, située à l'intérieur du réchauffeur supérieur, pourvue d'un creuset pour un matériau source et d'un couvercle de creuset permettant la fixation d'une graine monocristalline dessus,
dans laquelle
la graine monocristalline est placée dans une partie supérieure de la chambre de croissance, et le matériau source est placé dans le creuset,
la chambre de croissance est remplie d'un gaz inerte,
au moyen des réchauffeurs supérieur et inférieur, la graine monocristalline est chauffée jusqu'à une température d'au moins 2150°C, et le matériau source jusqu'à une température plus élevée, de préférence au moins 2300°C,
pendant le processus, la matière source est maintenue à une température plus élevée que la graine,
et dans ces conditions, la décomposition thermique du matériau source et la cristallisation du carbure de silicium sur la graine monocristalline sont effectuées pour donner un cristal de carbure de silicium,
**caractérisée en ce que**
pendant la cristallisation du carbure de silicium sur la graine monocristalline, la puissance $P_g$ fournie au réchauffeur supérieur (2) et la puissance $P_d$ fournie au réchauffeur inférieur (3) sont modifiées dans le temps en fonction de l'épaisseur du cristal en croissance (8) afin de changer le champ de température pendant la croissance des cristaux,
dans laquelle la surface arrière de la graine monocristalline (6), c'est-à-dire la surface qui, dans le processus de croissance, fait face à l'extérieur par rapport au creuset (9), est laissée découverte, et pendant la cristallisation du carbure de silicium sur la graine monocristalline (6)

d) tout d'abord, le rapport de puissance $P_g/P_d$ est minimisé, de préférence en fournissant la puissance $P_g$ plus faible au réchauffeur supérieur (2) et la puissance $P_d$ non supérieure à l'étape précédente au réchauffeur inférieur (3), jusqu'à ce que le cristal en croissance (8) atteigne un épaisseur d'environ 3 mm, et puis

e) le rapport de puissance $P_g/P_d$ est augmenté, de préférence en fournissant une puissance $P_g$ supérieure à l'étape précédente au réchauffeur supérieur (2), jusqu'à ce que le cristal en croissance (8) atteigne une épaisseur d'environ 30 mm, et puis

f) le rapport de puissance $P_g/P_d$ est réduit afin de maintenir la différence de température entre le matériau source et la surface du cristal en croissance, de préférence en fournissant une puissance $P_g$ supérieure à l'étape précédente au réchauffeur inférieur (3).

4. La méthode selon la revendication 3, **caractérisée en ce qu'**à l'étape e) la puissance $P_g$ fournie au réchauffeur supérieur (2) est progressivement augmenté au fil du temps.

5. La méthode selon la revendication 1 ou 3, **caractérisée en ce qu'**à l'étape c) ou f) la puissance $P_d$ fournie au réchauffeur inférieur (3) est progressivement augmenté au fil du temps.

6. La méthode selon l'une quelconque des revendications 1 à 5, **caractérisée en ce que** l'on utilise une graine (6) sous la forme d'une plaque avec une seule face avant polie.

7. La méthode selon l'une quelconque des revendications 1 à 5, **caractérisée en ce que** l'on utilise une graine (6) orientée cristallographiquement le long d'une direction cohérente avec l'axe cristallographique c.

8. La méthode selon l'une quelconque des revendications 1 à 5, **caractérisée en ce que** l'on utilise une graine (6) sous la forme d'une plaque d'une épaisseur de 1 à 2 mm.

9. La méthode selon l'une quelconque des revendications 1 à 5, **caractérisée en ce que** comme graine (6), une plaque 4H-SiC est utilisée, de préférence celle dont la surface de croissance, c'est-à-dire la surface qui dans le processus de croissance est tournée vers l'intérieur par rapport au creuset (9), a la polarité du carbone.

10. La méthode selon l'une quelconque des revendications 1 à 5, **caractérisée en ce que** comme graine (6), une plaque 6H-SiC est utilisée, de préférence celle dont la surface de croissance, c'est-à-dire la surface qui dans le processus de croissance est tournée vers l'intérieur par rapport au creuset (9), a la polarité du silicium.

11. La méthode selon l'une quelconque des revendications 1 à 10, **caractérisée en ce que** comme matériau source, l'on utilise du carbure de silicium, éventuellement dopé au bore, au vanadium ou à l'aluminium, ou du carbure de silicium de composition non stœchiométrique, contenant un excès de silicium ou de carbone.

12. La méthode selon l'une quelconque des revendications 1 à 11, **caractérisée en ce que** le gaz inerte contient de l'azote ou le gaz inerte est l'azote.

13. La méthode selon l'une quelconque des revendications 1 à 12, **caractérisée en ce que** la graine (6) est chauffée jusqu'à une température de 2150-2300°C sur sa surface arrière.

14. La méthode selon l'une quelconque des revendications 1 à 13, **caractérisée en ce que** le processus est effectué en utilisant un champ de température et un champ de pressions partielles de vapeurs à partir desquelles un cristal est formé, adaptés à la vitesse de croissance du cristal dans la plage de 0,01 à 2 mm/h.

**Fig. 1**.

**Fig. 2**.

**Fig. 3**

a)

I step

b)

II step

c)

III step

$$\frac{P_{g_I}}{P_{d_I}} > \frac{P_{g_{II}}}{P_{d_{II}}} > \frac{P_{g_{III}}}{P_{d_{III}}}$$

$P_g$ - power supplied to the upper heater

$P_d$ - power supplied to the lower heater

**Fig. 4.**

a)                              b)                              c)

I step                          II step                         III step

$$\frac{P_{g_I}}{P_{d_I}} < \frac{P_{g_{II}}}{P_{d_{II}}} > \frac{P_{g_{III}}}{P_{d_{III}}}$$

$P_g$ - power supplied to the upper heater

$P_d$ - power supplied to the lower heater

**Fig. 5**.

**Fig. 6.**

Fig. 7.

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 1354987 A
- EP 2371997 A

**Non-patent literature cited in the description**

- **A. J. LELY.** *Ber. Deut. Keram. Ges.,* 1955, vol. 32, 229
- **Y.M.TAIROV ; V.F.TSVETKOW.** *J.Crystal Growth,* 1978, vol. 43, 209
- **T. UJIHARA ; R. MAEKAWA ; R. TANAKA ; K. SASAKI ; K. KURODAB ; Y. TAKEDA.** *J. Cryst. Growth,* 2008, vol. 310, 1438
- **O. KORDINA ; C. HALLIN ; A. ELLISON ; A. S. BAKIN ; I. G. IVANOV ; A. HENRY ; R. YAKIMOVA ; M. TOUMINEN ; A. VEHANEN ; E. JANZEN.** *Appl. Phys. Lett.,* 1996, vol. 69, 1456
- **KRZYSZTOF GRASZA et al.** Experimental Verification of a Novel System for the Growth of SiC Single Crystals. *MATERIALS SCIENCE FORUM,* 01 March 2011, vol. 679-680, ISSN ISSN 0255-5476, 16-19
- **T.S SUDARSHAN ; S. I. MAXIMENKO.** *Microelectronic Engineering,* 2006, vol. 83, 155-159